(19) Europäisches Patentamt
European Patent Office
Office européen des brevets

(11) Publication number: 0 104 956 B1

# (12) EUROPEAN PATENT SPECIFICATION

(45) Date of publication of patent specification: 09.05.90

(51) Int. Cl.$^5$: B 41 J 5/12, H 03 K 17/965

(21) Application number: 83305858.9

(22) Date of filing: 28.09.83

## (54) Keyboard.

(30) Priority: 28.09.82 IT 6814182

(43) Date of publication of application:
04.04.84 Bulletin 84/14

(45) Publication of the grant of the patent:
09.05.90 Bulletin 90/19

(84) Designated Contracting States:
DE FR GB

(56) References cited:
DE-A-2 346 392
DE-A-2 411 426
DE-A-2 655 964
GB-A-2 046 996
GB-A-2 058 458
GB-A-2 058 462
US-A-3 707 609
US-A-3 797 630
US-A-3 900 712
US-A-3 924 090
US-A-4 029 916
US-A-4 129 758

(73) Proprietor: Ing. C. Olivetti & C., S.p.A.
Via G. Jervis 77
I-10015 Ivrea (Torino) (IT)

(72) Inventor: Berutto, Eugenio
Via Gramsci 10
I-10015 Ivrea (IT)
Inventor: Franchino, Giovanni
Via M D'Azeglio 9
I-10010 Tavagnasco (IT)
Inventor: Stella, Lino
Via Castellamonte 33/b
I-10010 Banchette (Turin) (IT)

(74) Representative: Pears, David Ashley et al
REDDIE & GROSE 16 Theobalds Road
London WC1X 8PL (GB)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).



Courier Press, Leamington Spa, England.

**Description**

The present invention relates to a contact type keyboard comprising an upper plate provided with a plurality of openings arranged beneath the upper plate, an electrical circuit printed on a circuit board facing the upper plate and having a plurality of pairs of fixed electric elements aligned with respective ones of said plurality of openings and a plurality of modular keys each removably mounted in one of the openings for operating on a respective pair of the electric elements. Each key comprises an actuation member, a central body guiding the actuation member and a movable contact to be moved through the actuation member towards and away from the corresponding pair of the electric elements and wherein the central body has a portion insertable into the opening fixing teeth, and a plurality of pins depending from the central body.

Such a keyboard is known from DE—A—2 411 426, in which the central body of the key is assembled with the circuit board by means of its fixing teeth. The upper plate of the keyboard is fixed to the circuit board by means of screws and the actuation members of the keys are operated by caps through respective stems which pass through the openings of the upper plate of the keyboard. Each movable contact is constituted by two tongues derived from a sprung metallic plate of square shape, which is deformed to provide a snap action. The spring plate is insulated from the circuit board by means of a suitable apertured insulative plate and both plates are provided with peripheral holes for being engaged with the pins depending from the key body.

This known keyboard suffers from the disadvantage that it does not permit individual modular keys to be easily removed. In fact, in order to replace even one of the keys, the entire keyboard has to be dismantled; that is to say, it is necessary to remove all the caps from the keys, remove the upper plate from the circuit board, replace the key or keys which are to be changed, put the upper plate and the circuit board back together again and refit the caps and stems on the respective keys. The upper plate has only a protective function, whilst the circuit board should support the stresses due to any overtravel force exerted on the key and to the assembling and dismantling operation of the keys. A circuit board is inherently not designed to resist to such stresses and so there is the risk of breakage. Moreover the known keyboard is expensive due to the cost of the metallic sprung plate used to define the movable contact and the further insulating plate.

A movable contact is known from GB—A—2 058 462 which is carried by a dome-like portion of a rubber sheet which raises from a planar base with a particular configuration. A movable contact of this type is not expensive. This reference does not concern itself with the manner in which keys are assembled to define a keyboard.

The invention aims to solve the problem of providing a keyboard which is reliable and economical and in which each modular key can be easily removed from the assembled keyboard for example to be exchanged for another key.

The present invention provides a contact type keyboard which is characterised in that each modular key further comprises upper transverse shoulders of the central body of the key engageable with an upper surface of the upper plate for removably mounting the central body in the opening of the upper plate, and a dome shaped spring of resilient rubber material having a dome portion carrying the movable contact and having a portion provided with a plurality of apertured projections fitting the plurality of pins. The fixing teeth of the key are provided to engage a lower surface of the upper plate and are carried by a pair of longitudinal resilient tongues having flexible portions extending from the central body, and being manually operable to remove the body and dome spring from the opening in the upper plate. Furthermore the apertured portion of the dome spring bears against the printed circuit board under the influence of the central body when the transverse shoulders of the body abut the upper surface of the upper plate.

These and other features of the invention will be more clearly apparent from the following description of a preferred embodiment described by way of example, only with reference to the accompanying drawings in which:

Figure 1 is a sectional side view of a contact-type keyboard according to the invention,

Figure 2 is an exploded side view of the keyboard of Figure 1.

Figure 3 is a plan view of part of the keyboard of Figure 1,

Figure 4 is a view in section taken along line 4—4 in Figure 3,

Figure 5 is a view in section taken along line 5—5 in Figure 3,

Figure 6 is a view in section taken along line 6—6 in Figure 3,

Figure 7 is the key of Figure 6 in an operating position,

Figure 8 is a force-displacement diagram of a first type of resilient element of the keyboard according to the second aspect of the invention,

Figure 9 is a force-displacement diagram of a second type of rssilient element of the keyboard according to the second aspect of the invention, and

Figure 10 is a force-displacement diagram of the resilient system associated with each key of the keyboard according to the second aspect of the invention.

Referring to Figure 1, a keyboard 10 comprises a metal support plate or panel 11 which is provided with a plurality of openings 12 each substantially an irregular octagon (see Figure 3). A key 15 is fitted into each opening 12, whereby the positions of the openings 12 in the panel 11 determine the positions assumed by the individual keys 15 when the keyboard 10 is assembled.

The mode of mounting the keys 15 on the panel 11 will be described in detail hereinafter.

A plate or panel 16 of insulating material is fixed in position below the metal plate 11 (see Figures 1 and 2) and parallel thereto. On its outward surface, the panel 16 carries a printed circuit 17 and the associated electronic components 18, while on its inward surface the panel 16 carries a plurality of pairs of conductors 20 and 21 (see Figure 3). Each pair of conductors 20 and 21 has two terminals 22 and 23 which are in the form of interengaged spirals and which are positioned below a respective opening 12, so as to be short-circuited upon actuation of the corresponding key 15, as will be seen hereinafter. The two panels 11 and 16 are fixed together by means of screws 25, with the interposition of spacer members 26 of plastics material. The spacer members are so shaped that they can be easily positioned between two adjacent keys 15, after the keys have been mounted in the support panel 11 (see Figures 3 and 5).

Each key 15 comprises a body portion 30 (see Figures 3 and 4) of plastics material, which has a lower base part 31 designed to be inserted into an opening 12, two vertical, hollow, cylindrical guide portions 32 and 33 disposed on opposite sides of a central axis 34 (see Figures 6 and 7), and two locking elements 36 and 37 (see Figures 3 and 4) which are aligned at 90° with respect to the guides 32 and 33.

The base part 31 is provided with a horizontal shoulder 50 arranged to co-operate with the upper surface of the panel 11, and two resilient vertical tongue portions 51 and 52 disposed at opposite sides of the base part 31 and arranged to cooperate with the bottom surface of the panel 11 by means of tooth portions 54 and 55.

An actuator 40 (see Figures 3, 6 and 7) which is movable in the direction of the axis 34 has two lateral cylindrical portions 41 and 42 which are disposed in the guides 31 and 32, and two side limbs 43 received in two grooves or channels 45 (see Figure 4) of the locking elements 36 and 37. The actuator 40 is provided with a central opening or cavity 46 (see Figures 6 and 7), within which is disposed a metal coil spring 48 having a substantially constant coefficient of elasticity. The spring 48 is precompressed with a predetermined loading of a few grams, in order to prevent undesired movements of the actuator 40 in consequence of light loadings applied to the actuator 40.

Provided in the upper part of the actuator 40 (see Figure 3) are two apertures 60 and legs 61 (see Figure 6) of a cap member 62 are arranged to be fitted into the apertures 60. Printed on the top part of the cap member 62 is the sign identifying the character or the symbol to which the key 15 relates (see Figure 3).

A striker 63 (see Figures 6 and 7) which is of substantially cylindrical form is movable in the direction of the central axis 34 in a hole 64 in the body portion 30 and its upper part cooperates with the coil spring 48. The lower part of the striker 63 bears on a resilient rubber element 65. The element 65 comprises a central cup or dome supported by four radial arms 66 disposed in a cruciform configuration (see Figure 3). Each arm 66 is provided with an opening 67 for receiving a corresponding pin portion 68 formed integrally on the body portion 30 of the key 15.

A cylindrical pellet member 69 (see Figures 6 and 7) made of conducting rubber is fixed to the underside of each dome 65 to short-circuit the subjacent electrical terminals 22 and 23 when the key 15 is actuated, thereby to generate a corresponding electrical signal.

The keyboard described above is assembled in the following manner:

First of all, each modular key 15 is separately assembled, by fitting the actuator 40 to the body portion 30 in such a way that the lateral cylindrical portions 41 and 42 of the actuator 40 housed in the vertical cylindrical guides 32 and 33 and the side limbs 43 are disposed in the grooves 45 of the locking elements 36 and 37. Then, the coil spring 48 followed by the striker 63 are inserted from underneath, through the hole 64. The dome spring 65 is fitted into place, care being taken to ensure that the lower pin portions 68 of the key portion 30 are fitted into the corresponding openings 67 of the four radial arms 66. Finally, the caps 62 are fitted, by inserting the legs 61 into the apertures 60 of the actuator 40.

When a key 15 has been assembled in that way, it is then fitted from above into an opening 12 in the support panel 11. The two resilient tongue portions 51 and 52 are deformed inwardly of the body portion 30 so as to permit the tooth portions 54 and 55 to pass through the opening 12 and to move into positions under the panel 11 (see Figure 4). in that position, the horizontal shoulder 50 bears against the upward surface of the panel 11.

The spacer members 26 are then positioned between the lower base parts 31 of the keys 15 which have already been assembled (see Figure 2), the lower panel 16 is set in position parallel to the panel 11 and the two panels 11 and 16 are locked together by means of the screws 25.

With the two panels 11 and 16 in the assembled condition, each individual key 15 can be easily removed from its opening 12. To remove a key, it is sufficient for the two flexible blade portions 51 and 52 of the body portion 30 to be bent inwardly of the body portion, in order to disengage them from the support panel 11, and then to lift the key upwardly. The structure described has the advantage that the force required for depressing the keys is borne by the support panel 11, which can be metal, not by the panel 16 on which the printed circuit 17 is arranged.

The mode of operation of each key 15 is as follows:

In the rest condition, the dome spring 65 and the coil spring 48 hold the actuator 40 in the upwardly displaced position (Figure 6). The member 69 of conducting rubber is spaced from the subjacent terminals 22 and 23, so that the latter are in an open condition.

Before describing the mode of performance of the resilient system formed by the springs 48 and 45, the mode of performance of each of the two springs will be briefly described.

Deformation of the coil spring 48 is directly porportional to the loading applied, both when it is compressed and when it is released, its coefficient of elasticity being substantially constant. Figure 8, which is a graph of force (F) against displacement (S) for the spring 48, therefore comprises two coincident rectilinear segments. The dome spring 65 on the other hand has the force-displacement graph shown in Figure 9 in which it is possible to distinguish a first section O—A in which an increase in force corresponds to an increase in the deformation of the spring, until the displacement $S_1$ is reached, corresponding to abrupt yielding of the dome; a second section A—B in which an increase in displacement corresponds to a decrease in force, due to the yielding of the dome, until the displacement $S_2$ is reached, corresponding to the position in which the pellet member 69 bears against the subjacent surface (16); and a third portion B—C in which, the dome having reached the end of its travel, there is no change in displacement corresponding to an increase in force.

The return motion C—B—D—O which is produced by progressively reducing the force on the spring 65 is similar to the forward motion but is not coincident therewith due to the loss of energy in the spring.

The performance of the resilient system formed by the coil spring 48 and the dome spring 65 is as shown in the Figure 10 graph.

The vertical portion O—E is due to the preloading of the spring 48; the portion E—F represents the sum of the deformations of the spring 48 and the spring 65 until a displaced position $S_3$ is reached, where the jump due to the sudden yielding of the dome 65 occurs; such yielding permits elongation of the spring 48, which is equivalent to a decrease in the force (position F—G). At G, abrupt contact occurs between the member 69 and the terminals 22 and 23, making contact between the terminals whereby a corresponding electrical signal may be produced in any known manner. In the portion G—H, with the dome spring 65 having reached the end of its travel, an increase in the force corresponds only to deformation of the coil spring 48, until the actuator 40 is brought mechanically to a stop (see Figure 7), after a displacement $S_4$. When the load on the resilient system is progressively released, there is a return portion H—I, during which the spring 48 gradually expands until reaching a non-zero displacement $S_5$. When point I is reached the reaction of the dome spring 65 overcomes the force of the coil spring 48, causing compression thereof (portion I—L). At that time, the member 69 abruptly disengages from the subjacent electrical terminals 22 and 23. The final part L—E—O of the return is similar to the initial starting movement.

It is apparent that modifications to the contact-type keyboard as described above may be made without departing from the scope of the present invention.

## Claims

1. A contact type keyboard (10) comprising an upper plate (11) provided with a plurality of openings (12) arranged beneath the plate; an electrical circuit (17) printed on a circuit board (16) facing the upper plate and having a plurality of pairs of fixed electric elements (22, 23) aligned with respective ones of said plurality of openings; and a plurality of modular keys each removably mounted in one of the openings for operating on a respective pair of said electric elements (22, 23) and each comprising an actuation member (40), a central body (30) guiding the actuation member, a movable contact (69) to be moved through the actuation member (40) towards and away from said corresponding pair of said electric elements, and wherein the central body has a portion (31) insertable into the opening, fixing teeth (54, 55), and a plurality of pins (68) depending from said body; characterised in that each modular key further comprises:

transverse upper shoulders (50) of the central body engageable with an upper surface of said plate (11) for removably mounting the central body in said opening; and

a dome shaped spring of resilient rubber material having a dome portion (65) carrying the movable contact (69) and having a portion provided with a plurality of apertured projections fitting the plurality of pins;

wherein the fixing teeth (54, 55) are provided to engage a lower surface of said upper plate (11), are carried by a pair of longitudinal resilient tongues having flexible portions (51, 52) extending from the central body, and being manually operable to remove the body and dome spring from the opening in the upper plate (11); and

wherein the apertured portion of the dome spring bears against the printed circuit board (16) under the influence of the central body when the transverse shoulders (50) of the body (30) abut the upper surface of said plate (11).

2. A keyboard according to claim 1, characterised in that four pins (68) depend from the said central body (30), in that the domed portion (65) of the spring carries a conductive element defining the movable contact (69), and in that the said apertured portion is provided with four anchor arms (66) disposed in a cruciform configuration and with four corresponding holed projections (67) at the extremities of said arms, wherein each of the four pins is engageable in an aperture in a respective one of the apertured projections.

3. A keyboard according to claim 1 or 2, further comprising a coil spring (48) connected with said actuation member (40) for the operation of the said movable contact (69), characterised by a striker element (63) guided by the actuation member (40) and inter-connecting the coil spring with the said dome portion (65).

4. A keyboard according to claim 3, characterised in that the central body comprises a central hole (64), and the striker element (63) is guided by the said central hole.

5. A keyboard according to any of the preceding claims, characterised in that the said central body (30) comprises a stop element for arresting the stroke of said actuation member, so as to cause said plate to receive any depression force when the actuation member is arrested by said stop element.

6. A keyboard according to any of the preceding claims, characterised in that flexible portions of the longitudinal resilient tongues comprise an upper part (51) of the tongues extending from said transverse shoulders.

7. A keyboard according to any of the preceding claims, characterised in that the said central body has a substantially square section and defines two longitudinal hollow cylindrical guide portions (32, 33) disposed on opposite sides with respect to a diagonal of said section, and in which said actuation member comprises two lateral portions (41, 42) guided by the said cylindrical guide portions.

**Patentansprüche**

1. Kontakt-Tastatur (10), die aufweist: eine obere Platte (11) mit einer Vielzahl von Öffnungen (12) unter der Platte; eine elektrische Schaltung (17), die auf eine Schaltungsplatte (16) gedruckt ist, die der oberen Platte zugekehrt ist und mehrere Paare befestigter elektrischer Elemente (22, 23) aufweist, die mit jeweils einer der Vielzahl von Öffnungen fluchten; und mehrere modulare Tasten, die jeweils lösbar in einer der Öffnungen zur Betätigung jeweils eines Paares der elektrischen Element (22, 23) angebracht sind und jeweils ein Betätigungsglied (40), einen mittleren Körper (30), der das Betätigungsglied führt, und einen beweglichen Kontakt (29), der über das Betätigungsglied (40) in Richtung zu den entsprechenden Paar der elektrischen Elemente und von diesem weg bewegbar ist, aufweisen, wobei der mittlere Körper einen in die Öffnung einführbaren Teil (31), Befestigungszähne (54, 55) und mehrere von dem erwähnten Körper aus nach unten ragende Zapfen (68) aufweist, dadurch gekennzeichnet, daß jede modulare Taste ferner aufweist:

transversale obere Schultern (50) des mittleren Körpers, der mit der Oberseite der erwähnten Platte (11) zur lösbaren Anbringung des mittleren Körpers in der erwähnten Öffnung zur Anlage bringbar ist, und

eine haubenförmige Feder aus elastischem Gummimaterial mit einem Haubenteil (65), der den beweglichen Kontakt (69) trägt und einen mit mehreren Lochvorsprüngen versehenen Teil aufweist, der die Zapfen passend aufnimmt;

wobei die Befestigungszähne (54, 55) so angeordnet sind, daß sie mit der Unterseite der oberen Platte (11) zur Anlage bringbar sind, durch ein Paar langgestreckter elastischer Zungen mit flexiblen Teilen (51, 52), die sich vom mittleren teil weg erstrecken, getragen werden und manuell betätigbar sind, um den Körper und die haubenförmige Feder aus der Öffnung der oberen Platte (11) zu entfernen; und

wobei der Lochteil der haubenförmigen Feder unter dem Einfluß des mittleren Körpers auf die gedruckte Schaltungsplatte (16) drückt, wenn die transversalen Schultern (50) des Körpers (30) an der Oberseite der Platte (11) anliegen.

2. Tastatur nach Anspruch 1, dadurch gekennzeichnet, daß vier Zapfen (68) von dem mittleren Körper (30) nach unten ragen daß der haubenförmige Teil (65) der Feder ein leitendes Element trägt, das den beweglichen Kontakt (69) bildet, und daß der Lochteil mit vier Haltearmen (66), die kreuzförmig angeordnet sind, und mit vier entsprechenden Lochvorsprüngen (67) an den Enden der Arme versehen ist, so daß jeder der vier Zapfen mit einem Loch in jeweils einem der Lochvorsprünge in Eingriff bringbar ist.

3. Tastatur nach Anspruch 1 oder 2 mit einer Schraubenfeder (48), die mit dem Betätigungsglied (40) zur Betätigung des beweglichen Kontaktes (69) verbunden ist, gekennzeichnet durch ein Schlagelement (63), das durch das Betätigungsglied (40) geführt wird und die Schraubenfeder mit dem haubenförmigen Teil (65) verbindet.

4. Tastatur nach Anspruch 3, dadurch gekennzeichnet, daß der mittlere Körper ein mittleres Loch (64) aufweist und das Schlagelement (63) in dem mittleren Loch geführt ist.

5. Tastatur nach einem der vorstehenden Ansprüche, dadurch gekennzeichnet, daß der mittlere Körper (30) ein Anschlagelement zum Anhalten des Hubes des Betätigungsglieds aufweist, so daß die Platte veranlaßt wird, eine Niederdrückkraft aufzunehmen, wenn das Betätigungsglied durch das Anschlagelement angehalten wird.

6. Tastatur nach einem der vorstehenden Ansprüche, dadurch gekennzeichnet, daß flexible Teile der langgestreckten elastischen Zungen einen oberen Abschnitt (51) der Zungen aufweisen, der von den transversalen Schultern absteht.

7. Tastatur nach einem der vorstehenden Ansprüche, dadurch gekennzeichnet, daß der mittlere Körper einen im wesentlichen quadratischen Querschnitt aufweist und zwei langgestreckte hohlzylindrische Führungsteile (32, 33) bildet, die auf sich gegenüberliegenden Seiten in bezug auf eine Diagonale des Querschnitts angeordnet sind, und daß das Betätigungslied zwei seitliche Teile (41, 42) aufweist, die durch die hohlzylindrischen Führungsteile geführt sind.

**Revendications**

1. Clavier (10) du type à contacts, qui comprend une plaque supérieure (11) présentant une pluralité d'ouvertures (12; et au-dessous de la plaque supérieure, un circuit électrique (17) imprimé sur un panneau de circuit (16), qui fait face à la plaque supérieure et possède une pluralité de paires d'éléments électriques fixes (22, 23) alignées respectivement sur les ouvertures correspondantes de ladite pluralité d'ouvertures, et une pluralité de touches modulaires dont chacune est montée amovible dans l'une des ouvertures pour opérer sur sa paire respective de éléments électriques (22, 23) et dont chacune comprend un élément d'actionnement (40), un corps central (30) qui guide l'élément d'actionnement, un contact mobile (69) destiné à être rapproché ou éloigné de ladite paire correspondante de contacts électriques au moyen de l'élément d'actionnement (40), et dans lequel le corps central possède une portion (31) qui peut être insérée dans l'ouverture, des dents de fixation (54, 55) et une pluralité d'ergots (68) qui saillent dudit corps, caractérisé en ce que chaque touche modulaire comprend en outre:

des épaulements transversaux supérieurs (50) du corps central de la touche qui peuvent entrer en prise avec une surface supérieure de la plaque (11) pour monter le corps central de façon amovible dans ladite ouverture; et

un ressort en forme de dôme en matière caoutchouteuse élastique possédant une portion bombée en dôme (65) qui porte le contact mobile (69) et possédant une portion munie d'une pluralité de bossages évidés qui reçoivent la pluralité d'ergots; dans lequel,

les dents de fixation (54, 55) sont prévues pour coopérer avec une surface inférieure de la plaque supérieure (11), sont portées par une paire de languettes élastiques longitudinales possédant des portions flexibles (51, 52) qui partent du corps central et qu'on peut manoeuvrer manuellement pour enlever le corps et le ressort bombé en dôme de l'ouverture de la plaque supérieure (11); et dans lequel

la portion évidée du ressort bombé en dôme porte contre le panneau de circuit imprimé (16) sous l'influence du corps central lorsque les épaulements transversaux (50) du corps butent contre la surface supérieure de la plaque supérieure (11).

2. Clavier selon la revendication 1, caractérisé en ce que quatre ergots (68) saillent du corps central (30), en ce que la portion bombée en dôme (65) du ressort porte un élément conducteur qui définit le contact mobile (69), et en ce que ladite portion évidée est munie de quatre bras d'ancrage (66) disposés dans une configuration cruciforme, et de quatre bossages évidés correspondants (67) situés aux extrémités desdits bras, chacun des quatre ergots pouvant s'emboîter respectivement dans l'un des bossages évidés.

3. Clavier selon la revendication 1 ou 2, comprenant en outre un ressort hélicoïdal (48) relié audit organe d'actionnement (40) pour actionner ledit contact mobile (69), caractérisé par un élément percuteur (63) guidé par l'organe d'actionnement (40) et reliant le ressort hélicoïdal à ladite portion en dôme (65).

4. Clavier selon la revendication 3, caractérisé en ce que le corps central présente un trou central (64) et l'élément percuteur (63) est guidé par ledit trou central.

5. Clavier selon une quelconque des revendications précédentes, caractérisé en ce que ledit corps central (30) comprend un élément d'arrêt servant à arrêter la course dudit élément d'actionnement et à faire en sorte que ladite plaque reçoive une force de dépression lorsque l'élément d'actionnement est arrêté par ledit élément d'arrêt.

6. Clavier selon une quelconque des revendications précédentes, caractérisé en ce que des portions flexibles des languettes élastiques longitudinales constituent une partie supérieure des languettes qui partent desdits épaulements transversaux.

7. Clavier selon une quelconque des revendications précédentes, caractérisé en ce que ledit corps central possède une section sensiblement carrée et définit deux portions guides cylindriques creuses longitudinales (32, 33) disposées de part et d'autre d'une diagonale de ladite section, et en ce que ledit élément d'actionnement comprend deux portions latérales (41, 42) guidées par lesdites portions guides cylindriques.

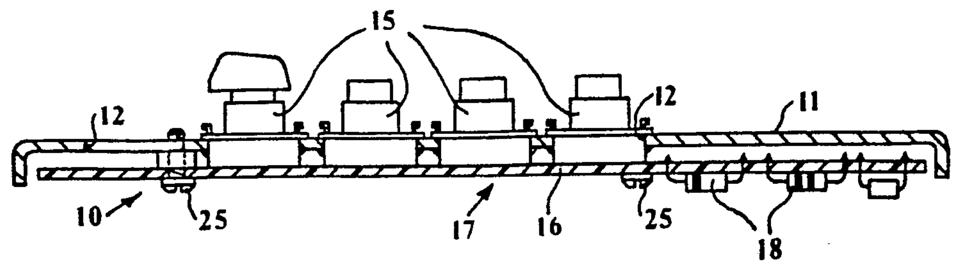


FIG.1

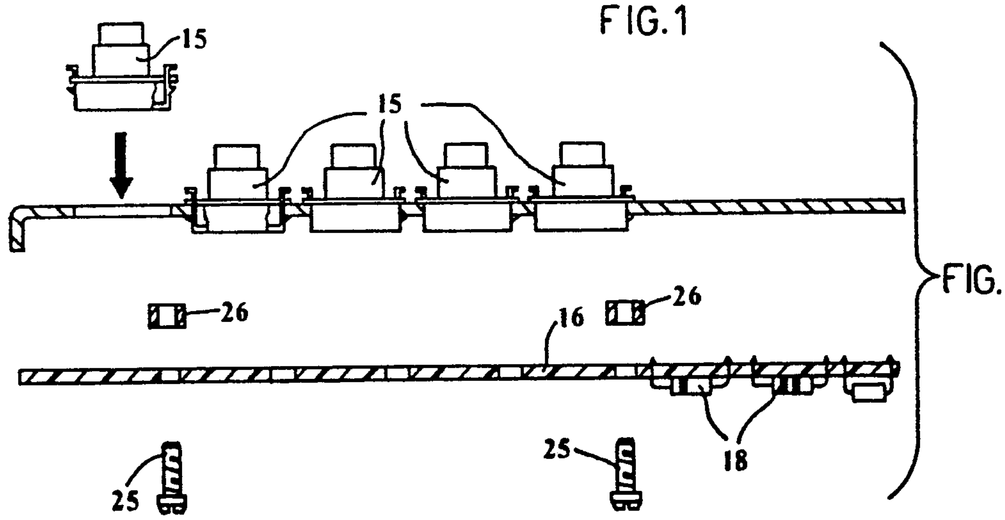


FIG.2

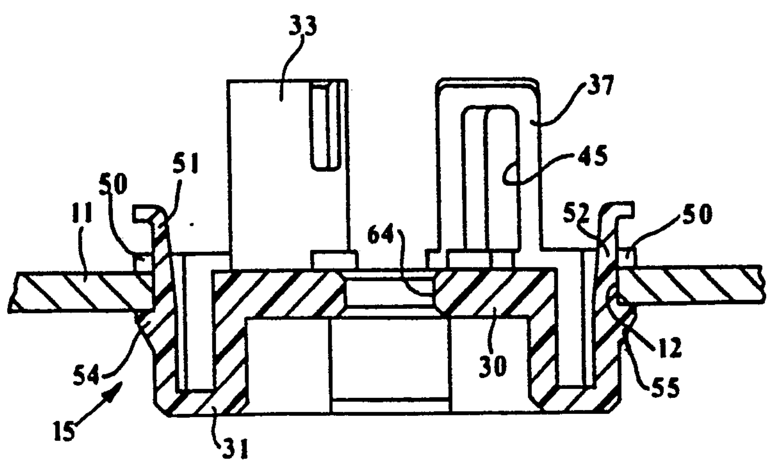


FIG.4

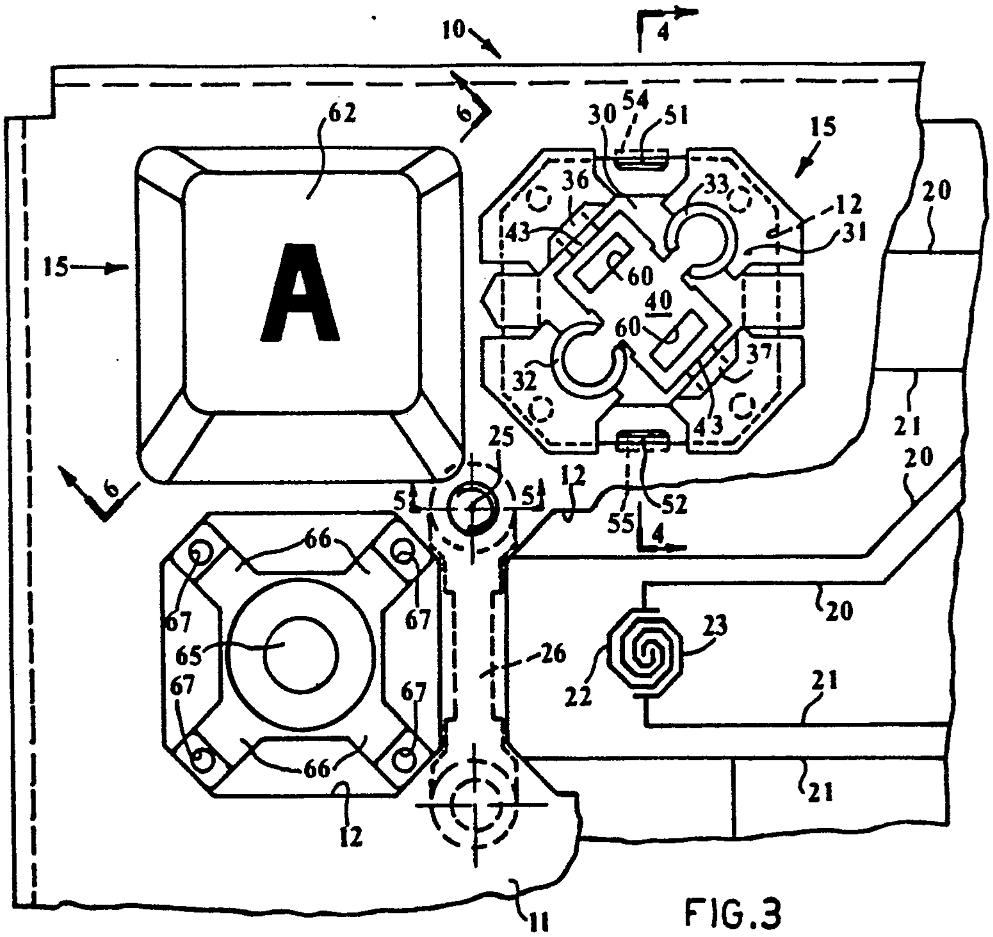
10
4
6
62
30
54
51
15
36
33
12
20
15
43
31
A
60
40
60
37
32
43
21
25
20
6
5
5
12
52
55
4
66
67
67
20
65
26
23
67
67
22
21
66
21
12
11

FIG.3

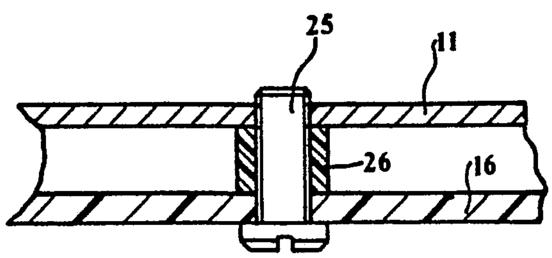
25
11
26
16

FIG.5

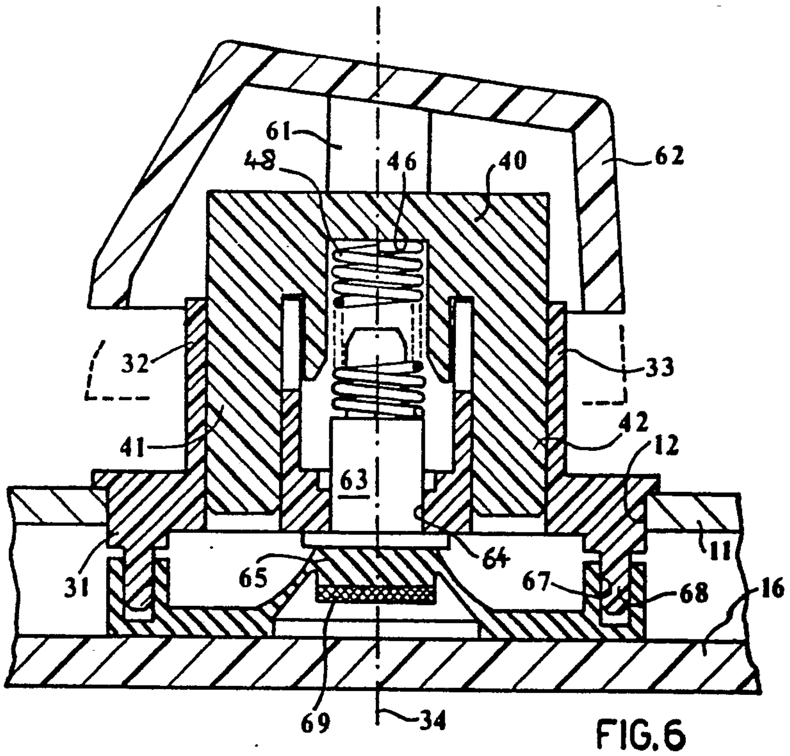
61
48
46
40
62
32
33
41
42
12
63
11
31
64
65
67
68
16
69
34

FIG.6

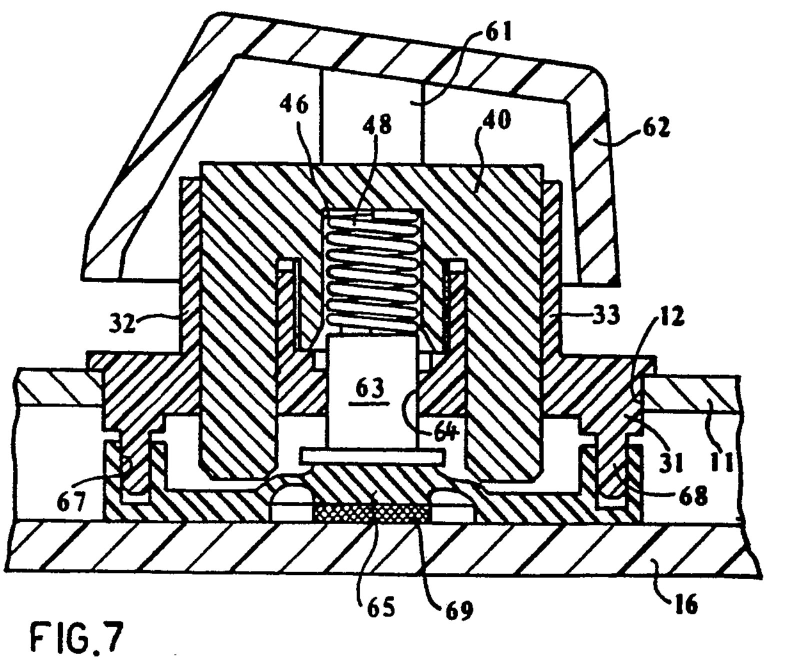
61
46
48
40
62
32
33
12
63
64
31
11
67
68
65
69
16

FIG.7

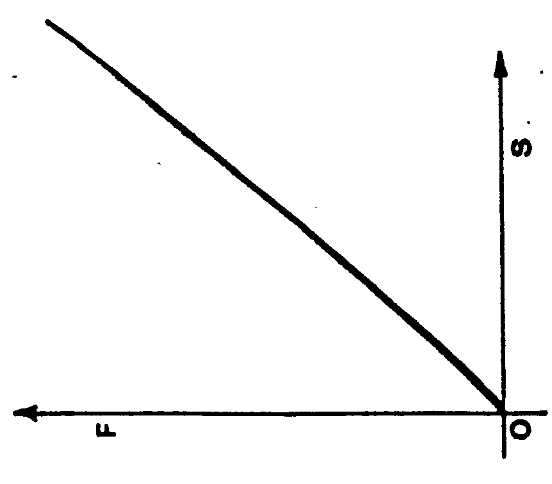


FIG.8

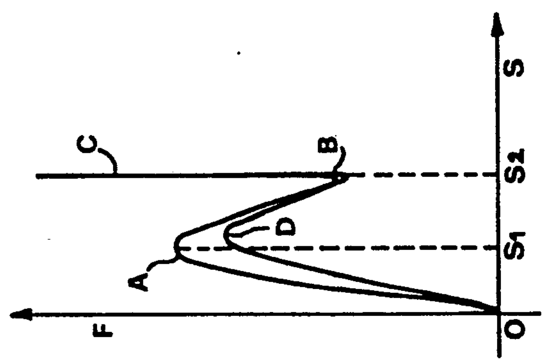


FIG.9

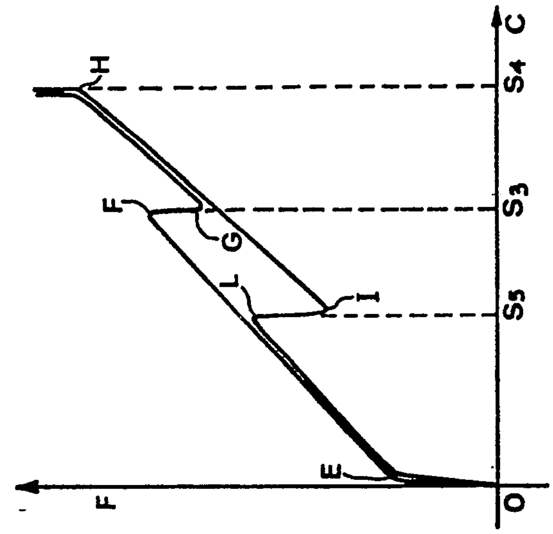


FIG.10